# EUROPÄISCHE PATENTSCHRIFT

(11) **EP 1 291 077 B1**
(45) Veröffentlichungstag und Bekanntmachung des Hinweises auf die Patenterteilung: **19.09.2007**
(21) Anmeldenummer: 02019349.6
(22) Anmeldetag: 29.08.2002
(51) Int. Cl.: B01J 19/12, H05B 6/80, B01J 19/24, H05H 1/24, H05B 6/78

(54) **Mikrowellenreaktor und Verfahren zur Steuerung von Reaktionen von aktivierten Molekülen**
Microwave reactor and method for controlling reactions of activated molecules
Réacteur hyperfrequences et procédé pour contrôler des réactions de molécules activées

(30) Priorität: 05.09.2001 DE 10143377
(43) Veröffentlichungstag der Anmeldung: 12.03.2003
(73) Patentinhaber: Deutsches Zentrum für Luft- und Raumfahrt e.V., 51147 Köln (DE)
(72) Erfinder: Holzschuh, Frank, 74354 Besigheim (DE); Prothmann, Reinhold, 73732 Esslingen (DE); Renz, Günther, Dr., 70794 Filderstadt (DE); Nedele, Martin, Dr., 72768 Reutlingen (DE)
(74) Vertreter: Hoeger, Stellrecht & Partner Patentanwälte

(56) Entgegenhaltungen:
- EP-A- 0 489 078
- DE-A- 19 701 094
- US-A- 4 365 587
- US-A- 4 644 877

## Beschreibung

Die Erfindung betrifft einen Mikrowellenreaktor, umfassend einen Mikrowellengenerator, einen Hohlleiter, welcher an den Mikrowellengenerator gekoppelt ist und in dem eine stehende elektromagnetische Welle erzeugbar ist, ein Fluidrohr, durch welches in einer Fluidführungsrichtung ein Fluid quer zur Ausbreitungsrichtung der stehenden elektromagnetischen Welle führbar ist, wodurch ein Aktivatorraum ausgebildet ist, in dem Moleküle im Fluidstrom durch Dissoziation und/oder Ionisation aktivierbar sind, und ein auf den Aktivatorraum in Fluidführungsrichtung folgender Reaktionsraum folgt, in welchem aktivierte Moleküle als Reaktanden einsetzbar sind.

Ein Mikrowellenreaktor ist beispielsweise aus der EP 0 489 078 B1 bekannt.

Aus der US 4,365,587 ist eine Vorrichtung zur Herstellung eines dünnen organischen Films auf einem Substrat mittels eines Plasmas bekannt, welche eine Röhre zur Herstellung eines Mikrowellenplasmas und eine Reaktionskammer umfasst.

Der Erfindung liegt die Aufgabe zugrunde, einen Mikrowellenreaktor zu schaffen, welcher einen erweiterten Einsatzbereich aufweist.

Diese Aufgabe wird erfindungsgemäß dadurch gelöst, daß er Aktivatorraum von dem Reaktionsraum durch ein Metallgitter räumlich getrennt ist.

Da in dem Aktivatorraum aktivierte Moleküle gebildet werden, welche durch ihre Aktivierung eine erhöhte Reaktivität aufweisen, können diese in einem von dem Aktivatorraum getrennten Reaktionsraum für entsprechende Reaktionen mit anderen Reaktionspartnern eingesetzt werden.

Der Mikrowellenreaktor selber ist daher zweigeteilt, nämlich in einem Aktivatorraum zur Aktivierung der Moleküle und in einen Reaktionsraum, in dem die aktivierten Moleküle als Reaktanden genutzt werden.

Der Aktivatorraum ist von dem Reaktionsraum durch ein Metallgitter getrennt. Über ein solches Metallgitter, welches insbesondere eine Maschenweite kleiner als eine halbe Wellenlänge der stehenden Welle aufweist, und vorzugsweise eine Maschenweite, welche kleiner ist als 1/10 dieser Wellenlänge, läßt sich eine Entladung des Fluids von dem Aktivatorraum in den Reaktionsraum hinaus im wesentlichen unterdrücken, da die Mikrowelle auf den Bereich des Aktivatorraums beschränkt wird. Dadurch sind dann bezüglich der Fluidführung Aktivatorraum und Reaktionsraum miteinander verbunden, während bezüglich der Plasmabildung diese getrennt sind, das heißt, die Mikrowelle kann den Reaktionsraum nicht beaufschlagen.

Insbesondere ist es dann vorteilhaft, wenn der Reaktionsraum ein oder mehrere Einkopplungsanschlüsse aufweist, über den oder die Reaktionspartner den aktivierten Molekülen zuführbar sind. Auf diese Weise lassen sich dann beispielsweise mit Hilfe der aktivierten Moleküle Synthesen durchführen, wobei diese Reaktionen entsprechend steuerbar sind.

Vorteilhafterweise ist die Temperatur im Reaktionsraum im wesentlichen unabhängig von der im Aktivatorraum steuerbar. Über eine entsprechende Temperatursteuerung lassen sich dann also die Bedingungen im Reaktionsraum und damit die Bedingungen für die Reaktion der Reaktanden mit Reaktionspartnern einstellen. Dadurch wiederum lassen sich gezielt bestimmte Reaktionen durchführen, um beispielsweise bestimmte synthetisierte Stoffe zu erhalten.

Vorteilhafterweise weisen dazu Aktivatorraum und Reaktionsraum getrennte Kühlsysteme auf, um eine Trennung zwischen Aktivierung von Molekülen als Eingangsmoleküle für den Reaktionsraum zu erhalten und um mittels dieser Reaktanden in dem Reaktionsraum dann die entsprechenden Reaktionen durchführen zu können.

Vorteilhafterweise weist der Aktivatorraum eine zylindrische Gestalt auf, um in diesem einen hohen räumlichen Aktivierungsgrad zu erhalten. Ein derart ausgestalteter Aktivierungsraum ist auch auf einfache Weise kühlbar.

Insbesondere ist dazu der Aktivatorraum durch ein oder mehrere Ringkanäle als Kühlkanäle konzentrisch umgeben. Dadurch lassen sich zum einen Begrenzungswände des Aktivatorraums großflächig kühlen und zum anderen läßt sich beispielsweise Kühlmittel in Gegenströmung zu einer Fluidführungsrichtung durch den Ringkanal führen.

Insbesondere wird als Kühlmittel eine Flüssigkeit eingesetzt, welche eine hohe Wärmeaufnahmefähigkeit hat. Es hat sich als vorteilhaft erwiesen, wenn der Aktivatorraum durch Silikonöl als Kühlflüssigkeit gekühlt ist.

Ferner ist es günstig, wenn der Reaktionsraum eine zylindrische Gestalt hat und von einem oder mehreren Ringkanälen als Kühlmittelkanälen umgeben ist.

Eine Steuerung der Temperatur im Reaktionsraum erfolgt dabei auf vorteilhafte Weise über Kühlmittelbeaufschlagung von Reaktionsraumwänden. Insbesondere läßt sich durch Eingangskühlmitteltemperatur und Kühlmitteldurchsatz eine entsprechende Temperatur einstellen, wodurch sich wiederum die Reaktionsbedingungen im Reaktionsraum für die Reaktion der aktivierten Moleküle mit entsprechenden Reaktionspartnern einstellen lassen.

Günstigerweise ist der Aktivatorraum in Fluidführungsrichtung durch ein erstes Metallgitter und ein beabstandet angeordnetes zweites Metallgitter begrenzt. Dadurch wird das Mikrowellenplasma in dem Aktivatorraum trotz des strömenden Fluids nicht strömungsabwärts und auch nicht strömungsaufwärts verschleppt, sondern bleibt im Aktivatorraum und steht für die Aktivierung der Moleküle über Elektronenstoßprozesse zur Verfügung.

Grundsätzlich ist es möglich, daß der Aktivatorraum und der Reaktionsraum in miteinander gekoppelten aber getrennten Fluidrohren angeordnet sind. Vorteilhafterweise sind diese aber in dem gleiche Fluidrohr gebildet, wobei sie eben durch ein Metallgitter getrennt sind.

Günstigerweise ist ein Fluidrohr aus einem Quarzglasrohr gebildet. Damit läßt sich ein Fluidrohr auf einfache Weise herstellen, es weist eine große Hitzestabilität auf, es ist Mikrowellen-durchlässig und darüber hinaus läßt sich noch ein Beobachtungsfenster bilden, mit dem die Plasmabildung unter Umständen auch spektroskopisch untersucht werden kann.

Ganz besonders vorteilhaft ist es, wenn zur konvektiven Kühlbarkeit des Fluids im Aktivatorraum dieses in turbulenter Strömung durch diesen geführt wird. Dadurch läßt sich im Vergleich zu einer laminaren Strömung die Wärmeabführbarkeit aus dem Aktivatorraum erheblich verbessern. Das gleiche gilt grundsätzlich auch für die Wärmeabführung aus dem Reaktionsraum.

Günstigerweise ist der Hohlleiter so abstimmbar, daß eine Wellenlänge der stehenden Mikrowelle einstellbar ist. Ferner ist es günstig, wenn der Hohlleiter so abstimmbar ist, daß ein Wellenbauch der stehenden elektromagnetischen Welle im Aktivatorraum liegt.

Die Erfindung betrifft ferner ein Verfahren zur Steuerung von Reaktionen von aktivierten Molekülen, bei welchem ein Fluid mit den Molekülen durch einen Aktivatorraum geführt wird, welcher durch eine stehende elektromagnetische Welle beaufschlagt ist und in dem die Moleküle durch Dissoziation und/oder Ionisation aktiviert werden, dadurch gekennzeichnet, daß die aktivierten Moleküle vom Aktivatorraum durch ein Metallgitter hindurch in einen Reaktionsraum geführt werden, in welchem sie als Reaktanden eingesetzt werden.

Dieses erfindungsgemäße Verfahren weist die bereits im Zusammenhang mit der erfindungsgemäßen Vorrichtung erläuterten Vorteile auf.

Insbesondere ist es günstig, wenn in den Reaktionsraum weitere Reaktionspartner für die aktivierten Moleküle eingeführt werden. Dadurch lassen sich beispielsweise mittels der aktivierten Moleküle Synthesen durchführen.

Günstigerweise ist dabei die Temperatur im Reaktionsraum unabhängig von dem Aktivatorraum gesteuert, um so unabhängig von den Aktivierungsparametern die Reaktionen im Reaktionsraum steuern zu können.

Dies läßt sich auf einfache Weise dadurch erreichen, daß für den Aktivatorraum und den Reaktionsraum unabhängige Kühlsysteme vorgesehen sind.

Weitere vorteilhafte Ausgestaltungen des erfindungsgemäßen Verfahrens wurden bereits im Verfahren mit der erfindungsgemäßen Vorrichtung erläutert.

Die nachfolgende Beschreibung bevorzugter Ausführungsformen dient im Zusammenhang mit der Zeichnung der näheren Erläuterung der Erfindung. Es zeigen:
- Figur 1: eine perspektivische Ansicht einer erfindungsgemäßen Pyrolysevorrichtung in Explosionsdarstellung;
- Figur 2: eine seitliche Schnittansicht durch ein Fluidrohr;

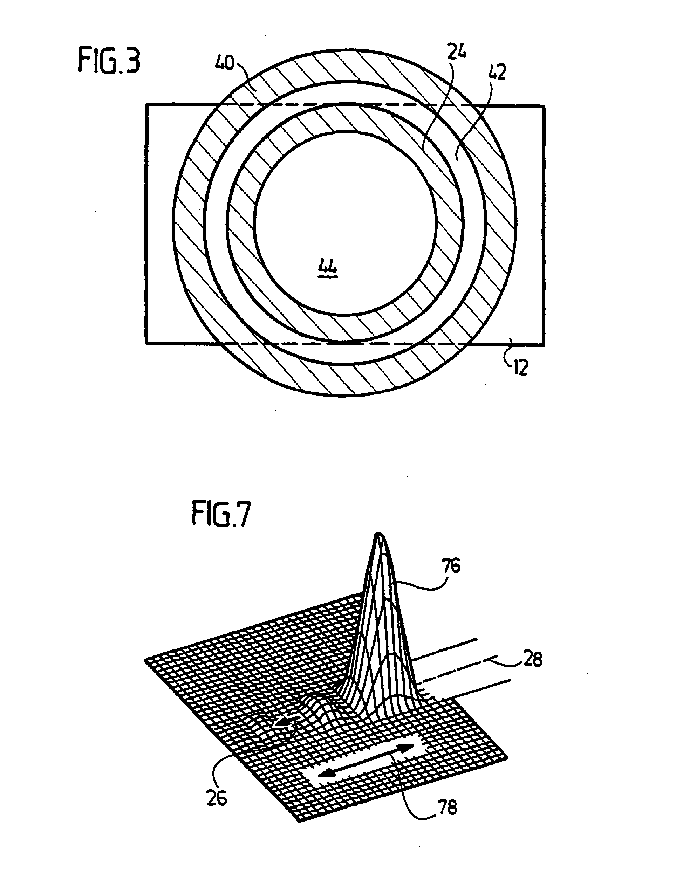

- Figur 3: eine schematische Querschnittansicht durch das Fluidrohr gemäß Figur 2 senkrecht zu der dortigen Zeichenebene;
- Figur 4: eine Darstellung des räumlichen Verlaufs der Feldstärkenteile Eₓ, E_{y} in einem Hohlleiter und in dem Fluidrohr;

- Figur 5: die gleiche Ansicht wie in Figur 4, wobei der Verlauf der Feldstärkenkomponente E_{z} gezeigt ist und Punkte Feldstärkevektoren bedeuten, die aus der Zeichenebene führen und Kreuze, bei denen die Richtung in die Zeichenebene ist;
- Figur 6: eine schematische Ansicht eines Fluidrohrs mit Aktivatorraum und Reaktionsraum;
- Figur 7: eine zeitliche Momentaufnahme einer in dem Fluidrohr propagierenden Anregungswelle, wenn keine Metallgitter vorgesehen sind, und
- Figur 8: Meßergebnisse von Abbauraten über der Mikrowellenleistung, welche mittels einer erfindungsgemäßen Vorrichtung an einem Dichlormethan-Luftgemisch mit einem Dichlormethan-Anteil von 1.600 ppm gewonnen wurden; die verschiedenen Kurven gehören zu verschiedenen Drücken und Durchflußraten.

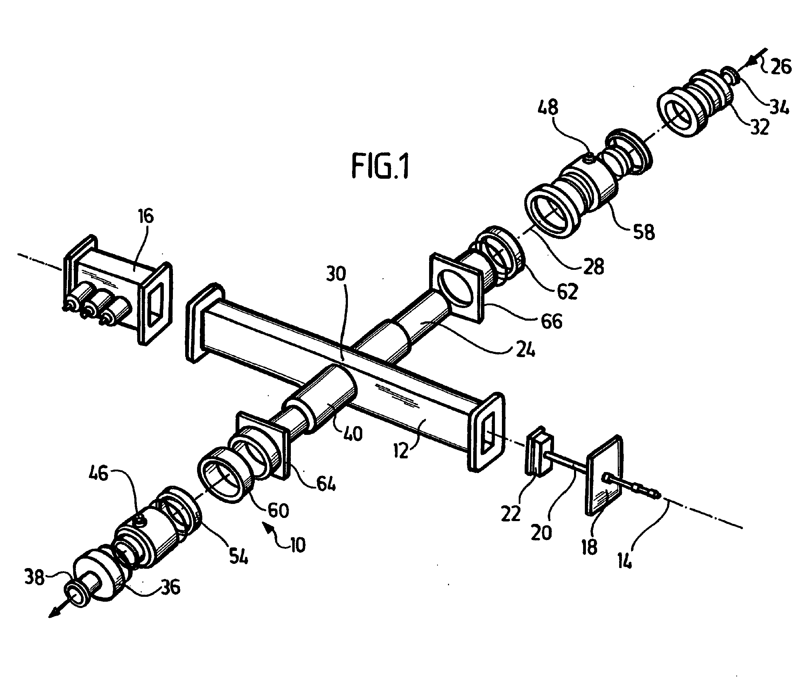

Bei einem Ausführungsbeispiel einer erfindungsgemäßen Pyrolysevorrichtung, welche in Figur 1 als Ganzes mit 10 bezeichnet ist, ist ein Rechteckhohlleiter 12 an einen Mikrowellengenerator (in der Zeichnung nicht gezeigt) gekoppelt, welcher Mikrowellen erzeugt. In dem Hohlleiter 12 können sich dabei stehende Wellen ausbilden mit einer Ausbreitungsrichtung parallel zu einer Längsrichtung 14 des Hohlleiters 12. Insbesondere können sich stehende Wellen im S-Band ausbilden.

Der Mikrowellengenerator liefert Mikrowellen im Frequenzbereich beispielsweise zwischen 0,5 GHz und 5 GHz.

Es kann vorgesehen sein, daß an einem Ende des Hohlleiters 12 eine Reflexionsmeßzelle 16 angeordnet ist, um die Reflexion zu messen. Mit ihrer Hilfe läßt sich auch die Einkopplung der Mikrowellenleistung in den Hohlleiter 12 optimieren; der Mikrowellengenerator ist der Reflexionsmeßzelle 16 dann nachgeschaltet angeordnet.

Am anderen Ende des Hohlleiters 12 sitzt eine Lagerplatte 18, in welcher eine Spindel 20 verschieblich gelagert ist, welche wiederum eine Hohlleiterwand 22 hält. Durch Verschiebung dieser Spindel 20 relativ zur Lagerplatte 18 läßt sich der Abstand der Hohlleiterwand 22 zu eben dieser Lagerplatte 18 einstellen, um so auf diese Weise eine Anpassung der für die Ausbildung einer stehenden elektromagnetischen Welle effektiven Hohlleiterbegrenzungsflächen durchführen zu können. Insbesondere läßt sich die Hohlleiterwand 22 so verschieben, daß bei gegebener Frequenz die stehende Welle sich ausbildet und darüber hinaus noch ein Wellenbauch als Bereich größter Strahlungsdichte dort liegt, wo ein Fluid durch den Hohlleiter 12 geführt ist.

Durch das elektromagnetische Wellenfeld, welches in dem Hohlleiter 12 bildbar ist, läßt sich ein Fluid durchführen. Dazu ist ein Fluidrohr 24 durch den Hohlleiter 12 hindurchgeführt und zwar insbesondere in einem mittigen Bereich des Hohlleiters 12 mit einer Fluidführungsrichtung 26 quer und insbesondere senkrecht zur Längsrichtung 14 des Hohlleiters 12.

Das Fluidrohr 24 ist dazu zylindrisch ausgebildet mit einer Achse 28, welche bezogen auf eine Querrichtung zur Längsrichtung 14 bevorzugterweise mittig durch den Hohlleiter 12 tritt. Das Fluidrohr 24 ist dabei beispielsweise aus Quarzglas hergestellt, um neben hoher Hitzebeständigkeit die Durchlässigkeit der Mikrowellen zu gewährleisten.

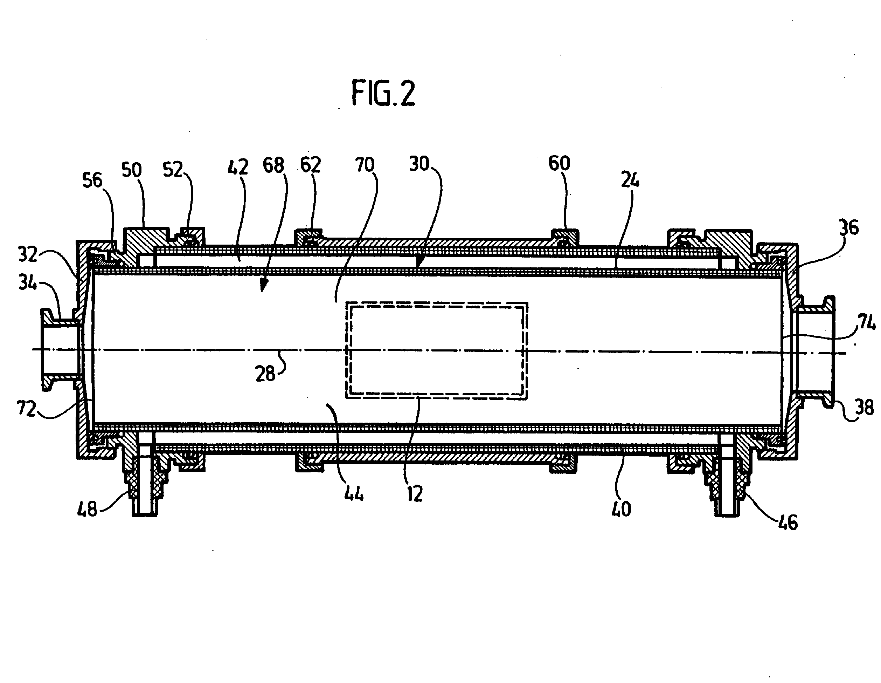

Derjenige Bereich 30 des Fluidrohrs 24 (vergleiche Figur 2), welcher durch den Hohlleiter 12 geführt ist, ist dadurch mit elektromagnetischer Strahlungsenergie beaufschlagbar.

Das Fluidrohr 24 ist mit einem Eingangsflansch 32 versehen, welcher einen Anschlußstutzen 34 aufweist, über den ein Fluid in das Fluidrohr 24 einkoppelbar ist. Dazu läßt sich insbesondere an den Anschlußstutzen 34 eine entsprechende Fluidleitung koppeln.

An dem gegenüberliegenden Ende ist das Fluidrohr mit einem Ausgangsflansch 36 mit einem Anschlußstutzen 38 versehen, über den sich das Fluidrohr durchströmte Fluid aus diesem abführen läßt.

Bevorzugterweise weist dabei der Anschlußstutzen 34 einen kleineren Querschnitt auf als der Anschlußstutzen 38 für den Ausgang, um bei der Durchführung von Fluid mittels einer Pumpe Unterdruck an dem Anschlußstutzen 38 besser halten zu können, um so sicherzustellen, daß das Fluid, welches in das Fluidrohr 24 eingekoppelt wurde, auch wieder aus diesem abgeführt wird.

Das Fluidrohr 24 bildet ein Innenrohr, welches von einem Außenrohr 40 umgeben ist, welches ebenfalls zylindrisch ausgebildet ist mit einer Achse, welche mit der Achse 28 des Fluidrohrs 24 zusammenfällt. Dieses Außenrohr 40 ist beispielsweise ebenfalls aus Quarzglas hergestellt. Zwischen dem Außenrohr 40 und dem Fluidrohr 24 ist ein Ringraum 42 gebildet, welcher als Kühlmittelkanal wirkt, durch den sich ein Kühlmittel führen läßt, mit dem das Fluidrohr 24 kühlbar ist, um so Wärme aus einem Innenraum 44 des Fluidrohrs 24 abführen zu können.

Zur Ausbildung einer Gegenstromkühlung ist dabei ein Eintrittsanschluß 46 vorgesehen, wobei dieser Eintrittsanschluß in der Nähe des Ausgangsflansches 36 liegt. Über diesen Eintrittsanschluß 46 läßt sich ein Kühlmittel und insbesondere eine Kühlflüssigkeit in den Ringraum 42 einführen, wobei dieses Kühlmittel dann den Ringraum in Gegenrichtung zur Fluidführungsrichtung 26 durchströmt.

Über einen Austrittsanschluß 48, welcher in der Nähe des Eingangsflansches 32 angeordnet ist, läßt sich das entsprechend erhitzte Kühlmittel abführen.

Erfindungsgemäß wird, um eine hohe Kühlwirkung zu erzielen, eine Kühlfüssigkeit wie Silikonöl mit hoher Wärmeaufnahmefähigkeit eingesetzt. Beispielsweise wird Silikonöl mit einem Volumenstrom von 10 I pro Minute durch den Ringraum 42 gepumpt.

Zur Verbindung und Abstandshalterung zwischen dem Fluidrohr 24 als Innenrohr und dem Außenrohr 40 ist im Bereich des Eingangsflansches 32 eine erste Verbindungsvorrichtung 50 vorgesehen, welche an einem Ende 52 an einem mit dem Außenrohr 40 verbundenen beispielsweise ringförmigen Flansch 54 gehalten ist und an einem anderen Ende 56 an dem Fluidrohr 24 beispielsweise mittels des Eingangsflansches 32 gehalten ist.

Eine entsprechende zweite Verbindungsvorrichtung 58, welche insbesondere gleich ausgebildet ist wie die erste Verbindungsvorrichtung 50, hält das Außenrohr 40 relativ zum Innenrohr 24 im Bereich des Ausgangsflansches 36.

Es kann ferner vorgesehen sein, daß das Außenrohr 40 noch beabstandete Ringflansche 60, 62 hält, über die mittels weiteren jeweils zugeordneten Haltevorrichtungen 64, 66 das Außenrohr 40 relativ zu dem Hohlleiter 12 fixierbar ist, um so für eine zusätzliche Halterung zu sorgen.

In dem Innenraum 44 des Fluidrohrs 24 ist eine Pyrolysezelle 68 mit einem Aktivatorraum 70 gebildet. In diese Pyrolysezelle 68 lassen sich chemische Verbindungen thermisch zersetzen (mit oder ohne Sauerstoffzutritt), indem Moleküle über ein durch die stehende Welle erzeugtes Mikrowellenplasma durch Elektronenstoßprozesse angeregt werden. Diese Elektronenstoßprozesse im Plasma bewirken dabei eine Dissoziation und Ionisation von Molekülen oder eine Ionisation ohne vorherige Dissoziation.

Die Pyrolysezelle 68 ist, bezogen auf die Fluidführungsrichtung 26, durch ein erstes Metallgitter 72 und ein beabstandet davon angeordnetes zweites Metallgitter 74 (siehe Figur 2) "elektrisch" abgeschlossen, wobei die Fluidströmung durch die Metallgitter 72 und 74 im wesentlichen nicht behindert wird. Die Maschenweite der Metallgitter 72, 74 ist kleiner als die halbe Wellenlänge der stehenden Welle im Hohlleiter 12 und insbesondere kleiner als 1/10 dieser Wellenlänge. Dadurch ist jeweils ein Mikrowellenabschirmgitter gebildet, das die Ausbildung einer Entladungsdelle in Bereiche mit geringerer elektromagnetischer Energiedichte verhindert. Dadurch läßt sich der Bereich, in dem sich das Mikrowellenplasma bildet, auf den Bereich zwischen den beiden Metallgittern 72 und 74 begrenzen und damit entsprechend die Energieeinkopplung in das Fluid zur Mikrowellenplasmabildung begrenzen. Damit wiederum läßt sich eine hohe Leistungsdichte in das Fluid einkoppeln, da die Metallgitter 72 und 74 den Aktivatorraum 70 begrenzen.

Die Metallgitter 72 und 74 sind dabei parallel zueinander ausgerichtet mit einer Oberflächennormale im wesentlichen parallel zu der Achse 28.

Die Metallgitter 72 und 74 sitzen insbesondere so in dem Fluidrohr 24, daß zwischen ihnen der Hohlleiter 12 angeordnet ist, das heißt, daß damit ein Wellenbauch der stehenden elektromagnetischen Welle im Hohlleiter 12 dann auch zwischen den Metallgittern 72 und 74 liegt.

Über die gewählte Maschenweite läßt es sich einstellen, inwieweit noch eine Entladung sich über die Metallgitter 72 und 74 hinaus von dem Hohlleiter 12 weg ausdellt.

Es kann vorgesehen sein, daß die Metallgitter 72 und 74 jeweils auf einem bestimmten elektrischen Potential gehalten werden oder auf Float-Potentialen sitzen, das heißt auf einem elektrischen Potential sitzen, welches durch Ionentransport und Ionengeschwindigkeit in dem Fluidrohr 24 bestimmt ist.

Die Verschleppung des Mikrowellenplasmas im Fluidrohr 24 strömungsauswärts und strömungsaufwärts in der Fluidführungsrichtung 26 wird durch die Metallgitter 72 und 74 verhindert, so daß durch eine hohe Energieeinkopplung in den Aktivatorraum 70 der Pyrolysezelle 68 erreicht ist.

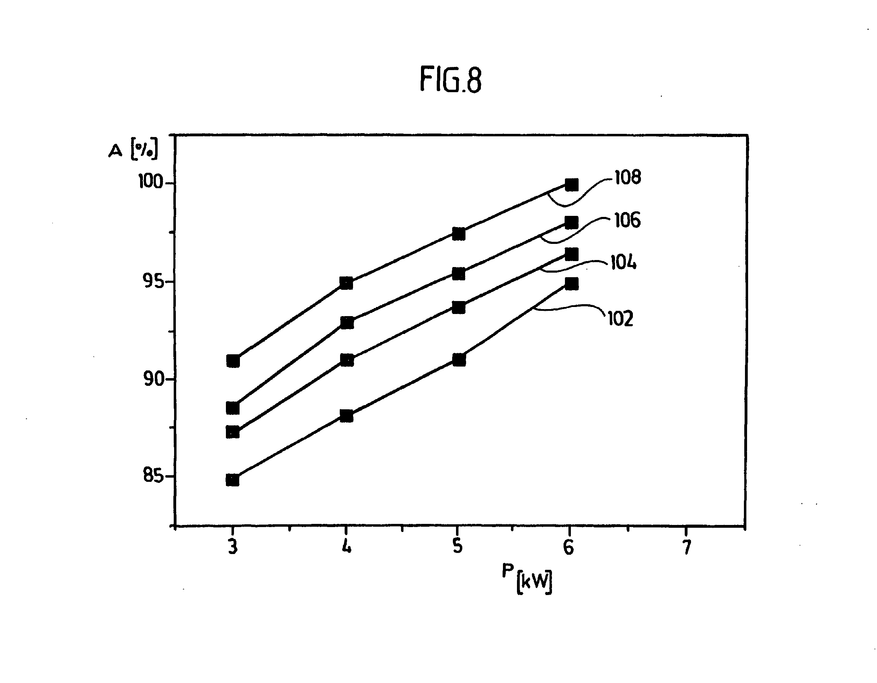

In Figur 7 ist eine Momentaufnahme einer Anregungswelle 76 in der Pyrolysezelle 68 gezeigt, wobei diese Welle eine Wellenlänge 78 aufweist; das Diagramm zeigt die Ergebnisse einer Simulation als Intensität über der Ebene der Achse 28 (x-y-Koordinaten), ohne daß der Aktivatorraum 70 durch die abschirmenden Metallgitter 72, 74 begrenzt ist. Dies hat, wie aus Figur 7 ersichtlich ist, zur Folge, daß sich eine Welle mit einem Ausbreitungsvektor parallel zur Fluidführungsrichtung 26 bildet, welche gewissermaßen Energiedichte aus dem Fluidrohr 24 abführt, die damit nicht mehr zur Anregung von Fluid in dem Fluidrohr 24 zur Verfügung steht.

Durch die Anordnung der Metallgitter 72 und 74 wird das Entstehen einer solchen Welle 76 weitgehend unterdrückt.

Das erfindungsgemäße Pyrolyseverfahren funktioniert wie folgt:

In dem Hohlleiter 12 wird eine stehende elektromagnetische Welle erzeugt mit einem Bauch, welcher in dem Bereich liegt, in dem das Fluid durch das Fluidrohr 24 durch den Hohlleiter 12 hindurchgeführt wird, das heißt, in der Pyrolysezelle 68. Der Mikrowellengenerator gibt dabei eine Leistung ab, die mindestens bei 3 kW liegt. Die Mikrowellenfrequenz liegt beispielsweise bei 2,45 GHz.

Ein Fluid wird durch den Aktivatorraum 70 als Pyrolysezelle 68 geführt mit einem Druck, welcher beispielsweise im Bereich zwischen 20 mbar und 1000 mbar liegt. Bei einem Luftgemisch ist beispielsweise eine Selbstzündung beim Anfahrdruck von 20 mbar eingetreten.

In dem Fluid, welches durch das Fluidrohr 24 strömt, wird dabei innerhalb des Aktivatorraums 70 ein Mikrowellenplasma gebildet. Durch Elektronenstoßprozesse der freien Elektronen im Mikrowellenplasma wiederum werden Moleküle im Fluid aktiviert über Dissoziation und/oder Ionisation. Wenn das Fluid ein Gemisch aus einem Trägerfluid und beispielsweise zu mineralisierenden organischen Schadstoffen darstellt, dann lassen sich dadurch diese organischen Schadstoffe, beispielsweise Chlor-Kohlenwasserstoffe oder Fluor-Kohlenwasserstoffe, abbauen und in unschädlichere beziehungsweise leichter zu verarbeitende Stoffe wie CO, CO₂, Nₓ, H₂O oder HCI zerlegen.

Dadurch, daß in dem Aktivatorraum 70 eine hohe Energiedichte vorliegt, muß für eine effektive Kühlung gesorgt werden. Dies erfolgt über eine Flüssigkeitskühlung über den Ringraum 42 gemäß einem Gegenstromprinzip, das heißt das Kühlmittel wird über den Eintrittsanschluß 46 in Richtung des Austrittsanschlusses 48 in Gegenrichtung zur Fluidführungsrichtung 26 durchgeführt. Um eine effektive Kühlung zu erhalten, wird ein konvektives Prinzip eingesetzt, das heißt, das Fluid wird in turbulenter Strömung durch das Fluidrohr 24 geführt, um eine lokale Wirbelbewegung im Fluid zu erhalten. Es bilden sich dann lokale Strömungswirbel, über die Fluid auf Begrenzungswände des Fluidrohrs 24 trifft, wobei davon wiederum Wärme über das Silikonöl im Ringraum 42 abführbar ist. Beispielsweise haben sich Reynolds-Zahlen größer als 10000 als vorteilhaft für eine effektive konvektive Kühlung des Fluidrohrs 24 erwiesen.

Durch eine turbulente Strömung des Fluids im Fluidrohr 24 ist auch erreicht, daß sich im wesentlichen keine Totpunkte im Aktivatorraum 70 bilden, in dem sich Schadstoffe ansammeln könnten. Darüber hinaus bestehen auch größere Wahlmöglichkeiten bei der Dimensionierung.

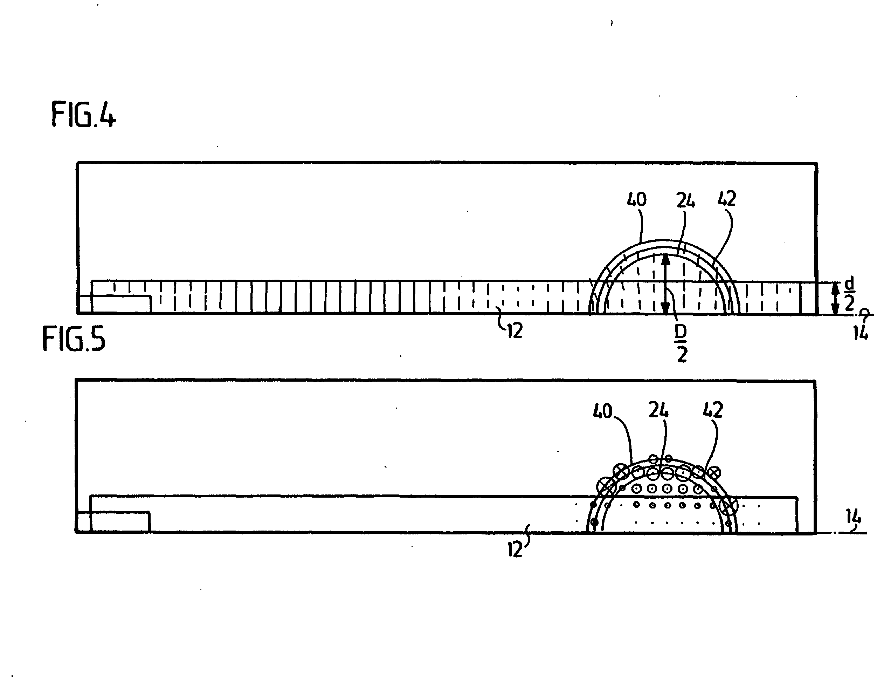

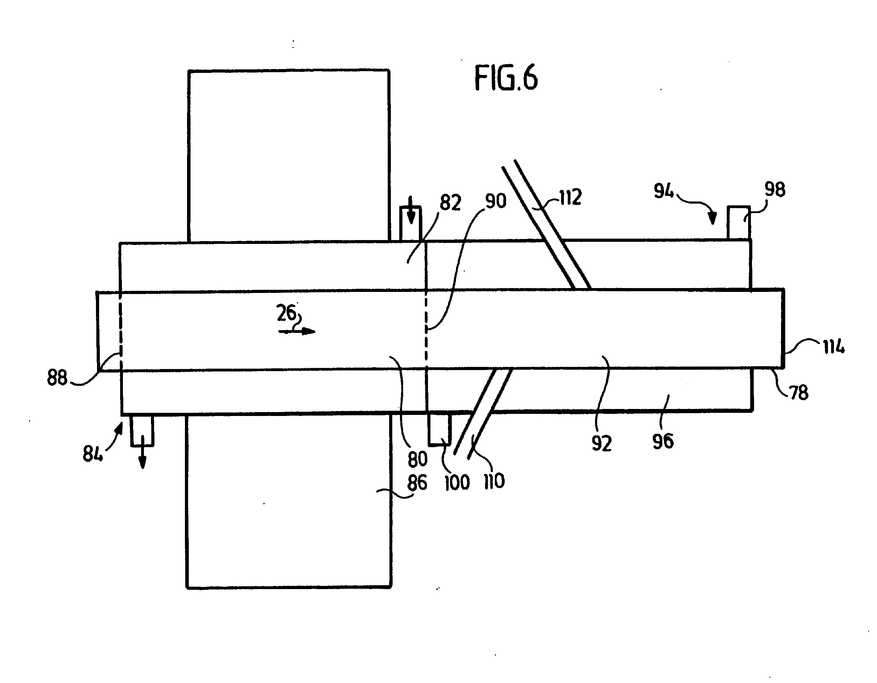

In den Figuren 4 und 5 ist beispielhaft der Verlauf der elektrischen Feldstärke der stehenden elektromagnetischen Welle im Hohlleiter 12 und im Fluidrohr 24 gezeigt, wobei in Figur 4 die Komponenten Eₓ, E_{y} gezeigt sind und in Figur 5 die Komponente E_{z} senkrecht dazu.

In Figur 4 deutet dabei die Strichlänge die Feldstärke an, wobei ersichtlich ist, daß im Bereich des Fluidrohrs 24 sich ein Wellenbauch ausbildet, so daß eine hohe Energiedichte einkoppelbar ist. Auch noch im Außenbereich des Fluidrohrs 24, das heißt im Bereich der Nähe des Ringraums 42, ist die Feldstärke genügend groß, daß eine hohe Energiedichte herrscht, um entsprechend ein Mikrowellenplasma anzuregen und dadurch wiederum über den ganzen Querschnitt des Fluidrohrs 24 Moleküle aktivieren zu können.

Es hat sich gezeigt, daß, wenn das Verhältnis eines Durchmessers D des Fluidrohrs 24 zu einer entsprechenden Querabmessung d des Hohlleiters 12 kleiner als etwa 5 und insbesondere kleiner als etwa 3 ist, selbst in den Randbereichen des Fluidrohrs 24 noch eine genügend große Energiedichte vorliegt.

Dieses Verhältnis ist skalierbar, das heißt bei entsprechender Vergrößerung des Durchmessers D des Fluidrohrs 24 können die entsprechenden Verhältnisse durch gleichsinnige Vergrößerung der Querabmessung d des Hohlleiters 12 erhalten werden.

Soll also beispielsweise ein größerer Volumendurchsatz durch ein Fluidrohr 24 eingestellt werden und dementsprechend der Durchmesser des Fluidrohrs 24 angepaßt werden, so kann durch gleichsinnige Vergrößerung des Hohlleiters 12 eine effektive Energieeinkopplung in das Fluidrohr 24 gewährleistet bleiben.

Die abschirmenden Metallgitter 72 und 74 bewirken, daß die Bildung einer propagierenden Welle 76, welche insbesondere bezogen auf die Fluidführungsrichtung 26 stromabwärts Energie aus dem Fluidrohr 24 abführen könnte, im wesentlichen unterdrückt wird.

Die in den Aktivatorraum 70 eingekoppelte Energie steht dann also mit hoher Effektivität für die Bildung des Mikrowellenplasmas und entsprechend zur Aktivierung der entsprechenden Moleküle in dem Fluid zur Verfügung.

Vorteilhafterweise wird das aus dem Aktivatorraum 70 über den Ausgangsflansch 36 abgeführte Fluid abgekühlt, so daß keine Rekombination der aktivierten Moleküle stattfinden kann, um so eine neuerliche Bildung von "Ausgangsmolekülen" weitgehend zu verhindern. Insbesondere erfolgt dabei ein schneller Abkühlungsprozeß.

In Figur 6 ist eine Variante eines Ausführungsbeispiels schematisch gezeigt, bei welcher innerhalb eines Fluidrohrs 78 ein Aktivatorraum 80 gebildet ist, welcher grundsätzlich gleich ausgebildet ist und funktioniert wie oben beschrieben. Insbesondere ist dieser Aktivatorraum 80 über einen Ringraum 82 mit einer Flüssigkeit und insbesondere Silikonöl kühlbar. Ein entsprechendes Kühlsystem ist in Figur 6 als Ganzes mit 84 bezeichnet.

Der Aktivatorraum 80 ist dabei durch eine Hohlleiter 86 geführt, in dem sich wie oben beschrieben eine stehende Welle ausbilden kann mit einem Wellenbauch in dem Aktivatorraum 80.

Der Aktivatorraum 80 ist wiederum durch ein erstes Metallgitter 88 und ein zweites Metallgitter 90 begrenzt, welche wiederum die gleiche Aufgabe haben wie oben anhand der Metallgitter 72 und 74 beschrieben.

Das zweite Metallgitter 90 trennt dabei den Aktivatorraum 70 von einem in dem Fluidrohr 24 gebildeten Reaktionsraum 92 ab. Dieser Reaktionsraum 92 weist ein Kühlsystem 94 auf, welches unabhängig von dem Kühlsystem 84 des Aktivatorraums 80 ist.

Über dieses Kühlsystem 94, welches einen den Reaktionsraum 92 umgebenden Ringraum 96 umfaßt, in dem ein Kühlmittel in Gegenstromrichtung zur Fluidführungsrichtung 26 durchführbar ist, läßt sich die Temperatur des Reaktionsraums 92 steuern.

Über einen Anschluß 98 läßt sich das Kühlmittel, insbesondere Wasser, in den Ringraum 96 einführen und über einen Anschluß 100 läßt sich das Kühlmittel abführen.

Der Reaktionsraum 92 kann dabei auch außerhalb des Fluidrohrs 78 angeordnet sein, indem beispielsweise dem Fluidrohr 24 ein entsprechendes Rohr nachgeschaltet wird, um einen Reaktionsraum zu bilden.

Erfindungsgemäß läßt sich nun durch den dem Aktivatorraum 80 nachgeschalteten Reaktionsraum 92 ein schneller Abkühlungsprozeß in dem aktivierten Fluid durchführen, um eine Rückbildung von beispielsweise organischen Molekülen nach der Dissoziierung zu verhindern. Dadurch läßt sich eben eine entsprechende Rekombination verhindern, die auch zur Bildung von Schadstoffen wie Dioxinen oder Furanen führen könnte.

In Figur 8 ist ein Beispiel einer Messung mit der erfindungsgemäßen Pyrolysevorrichtung gemäß dem erfindungsgemäßen Pyrolyseverfahren gezeigt, wobei ein bestimmter Volumenstrom eines Luftgemischs mit 1600 ppm Dichlormethan (dies entspricht dem Sättigungswert von Dichlormethan-Luftgemischen) durch das Fluidrohr 24 geführt wurde. Gezeigt ist die Abbaurate in Prozent (100 % bedeutet vollständiger Abbau von Dichlormethan) über der Mikrowellenleistung. Bei den Messungen war die maximal erreichbare Leistung des Mikrowellengenerators 6,0 kW bei einer Frequenz von 2,45 GHz. Die Kurve 102 zeigt dabei einen Durchsatz von 6000 l pro h bei einem Druck von 80 mbar in dem Fluidrohr 24. Die Kurve 104 zeigt die gemessenen Werte beim Durchsatz von 5000 I pro h bei einem Druck von 70 mbar, die Kurve 106 einen Durchsatz von 4000 I pro h bei einem Druck von 60 mbar und schließlich die Kurve 108 einen Durchsatz von 3000 I pro h bei einem Druck von 50 mbar.

Wie aus diesen gemessenen Daten ersichtlich ist, läßt sich auch bei hohen Durchsätzen bei entsprechender Steigerung der Mikrowellenleistung-Einkopplung eine hohe Abbaurate erreichen, die bei genügend hoher Leistungseinkopplung nahezu 100 % beträgt. Grundsätzlich ist dabei bei einer vorgegebenen Durchflußrate durch Erhöhung der Mikrowellenleistung das Abbauergebnis verbesserbar. Die erfindungsgemäße Vorrichtung und das erfindungsgemäße Verfahren lassen sich damit an die jeweilige Anwendung anpassen, das heißt je nach Durchflußrate läßt sich über Druckeinstellung und Leistungseinstellung das gewünschte Abbauergebnis erzielen.

Durch schnelle Abkühlung im Reaktionsraum 92 läßt sich dabei die Rekombination der dissoziierten Moleküle verhindern.

Messungen haben auch ergeben, daß beim Durchsatz von 3000 l pro h und einer Konzentration von 1500 ppm für Aceton eine Abbaurate größer als 99 %, für Toluol ebenfalls größer als 99 % und für Dichlormethan, wie in Figur 8 gezeigt, größer als 98 % erreichbar ist.

Die erfindungsgemäße Vorrichtung läßt sich dabei als "Tischgerät" ausbilden, das heißt sie ist transportabel. Mittels der erfindungsgemäßen Vorrichtung ist es grundsätzlich möglich, in dem Aktivatorraum 70 bzw. 80 mit Atmosphärendruck zu arbeiten, so daß auch dadurch eine Transportabilität gewährleistet ist.

Durch die erfindungsgemäße Pyrolysevorrichtung und das erfindungsgemäße Pyrolyseverfahren lassen sich somit beispielsweise organische Lösungsmittel abbauen und damit ist ein Verfahren und eine Vorrichtung zur Entsorgung von organischen Dämpfen, insbesondere von Lösemitteldämpfen, bereitgestellt.

Die erfindungsgemäße Vorrichtung läßt sich auch als Mikrowellenreaktor, insbesondere zur Durchführung eines Verfahrens zur Steuerung der Reaktion von aktivierten Molekülen, einsetzen. Die in dem Aktivatorraum 80 aktivierten Moleküle treten in den Reaktionsraum 92 und stellen dort grundsätzlich Reaktanden dar. Sie können dann mit weiteren Molekülen reagieren, wobei die Reaktionsbedingungen einstellbar sind. Zum einen läßt sich in gewissem Maße die Art der Aktivierung in dem Aktivatorraum 80 einstellen. Über das Kühlsystem 94 für den Reaktionsraum 92 lassen sich in diesem mittels Temperatursteuerung die Reaktionsbedingungen einstellen. Die dann als Reaktanden wirkenden aktivierten Moleküle lassen sich entsprechend einsetzen. Eine mögliche Anwendung ist beispielsweise die Essigsäureherstellung oder Ammoniaksynthese. Im letzteren Fall wird dann beispielsweise Stickstoff in dem Aktivatorraum 80 angeregt und Wasserstoff als Reaktionspartner wird in den Reaktionsraum 92 eingeführt.

Bei einer Variante einer Ausführungsform ist es dabei vorgesehen, daß über eine oder mehrere Zuführungsleitungen 110, 112, welche jeweils in den Reaktionsraum 92 münden, diesem Reaktionspartner für die Reaktanden - die aktivierten Moleküle - zuführbar sind.

Über einen Ausgang 114 lassen sich dann die Reaktionsprodukte abführen.

## Patentansprüche

1. Mikrowellenreaktor, umfassend einen Mikrowellengenerator, einen Hohlleiter (12), welcher an den Mikrowellengenerator gekoppelt ist und in dem eine stehende elektromagnetische Welle erzeugbar ist, ein Fluidrohr (78), durch welches in einer Fluidführungsrichtung (26) ein Fluid quer zur Ausbreitungsrichtung der stehenden elektromagnetischen Welle führbar ist, wodurch ein Aktivatorraum (80) ausgebildet ist, in dem Moleküle im Fluidstrom durch Dissoziation und/oder Ionisation aktivierbar sind, und ein auf den Aktivatorraum (80) in Fluidführungsrichtung (26) folgender Reaktionsraum (92) folgt, in welchem aktivierte Moleküle als Reaktanden einsetzbar sind,
**dadurch gekennzeichnet , daß** der Aktivatorraum (80) von dem Reaktionsraum (92) durch ein Metallgitter (90) räumlich getrennt ist.

2. Mikrowellenreaktor nach Anspruch 1, **dadurch gekennzeichnet, daß** der Reaktionsraum (92) ein oder mehrere Einkopplungsanschlüsse aufweist, über den oder die Reaktionspartner den aktivierten Molekülen zuführbar sind.

3. Mikrowellenreaktor nach Anspruch 1 oder 2, **dadurch gekennzeichnet, daß** die Temperatur im Reaktionsraum (92) im wesentlichen unabhängig von der im Aktivatorraum (80) steuerbar ist.

4. Mikrowellenreaktor nach einem der vorangehenden Ansprüche, **dadurch gekennzeichnet, daß** Aktivatorraum (80) und Reaktionsraum (92) getrennte Kühlsysteme (84, 94) aufweisen.

5. Mikrowellenreaktor nach einem der vorangehenden Ansprüche, **dadurch gekennzeichnet, daß** der Aktivatorraum (80) eine zylindrische Gestalt hat.

6. Mikrowellenreaktor nach Anspruch 5, **dadurch gekennzeichnet, daß** ein oder mehrere Ringkanäle (82) als Kühlkanäle den Aktivatorraum (80) konzentrisch umgeben.

7. Mikrowellenreaktor nach einem der vorangehenden Ansprüche, **dadurch gekennzeichnet, daß** Silikonöl als Kühlflüssigkeit für den Aktivatorraum (80) vorgesehen ist.

8. Mikrowellenreaktor nach einem der vorangehenden Ansprüche, **dadurch gekennzeichnet, daß** der Reaktionsraum (92) eine zylindrische Gestalt hat.

9. Mikrowellenreaktor nach Anspruch 8, **dadurch gekennzeichnet, daß** der Reaktionsraum (92) von einem oder mehreren Ringkanälen (96) als Kühlmittelkanäle umgeben ist.

10. Mikrowellenreaktor nach einem der vorangehenden Ansprüche, **dadurch gekennzeichnet, daß** eine Steuerung der Temperatur des Reaktionsraums (92) über Kühlmittelbeaufschlagung von Reaktionsraumwänden vorgesehen ist.

11. Mikrowellenreaktor nach einem der vorangehenden Ansprüche, **dadurch gekennzeichnet, daß** der Aktivatorraum (80) durch ein erstes Metallgitter (88) und ein in Fluidführungsrichtung (26) beabstandet angeordnetes zweites Metallgitter (90) begrenzt ist.

12. Mikrowellenreaktor nach einem der vorangehenden Ansprüche, **dadurch gekennzeichnet, daß** eine Maschenweite eines Metallgitters (88; 90) kleiner ist als eine halbe Wellenlänge der stehenden elektromagnetischen Welle.

13. Mikrowellenreaktor nach einem der vorangehenden Ansprüche, **dadurch gekennzeichnet, daß** Aktivatorraum (80) und Reaktionsraum (92) in dem Fluidrohr (78) gebildet sind.

14. Mikrowellenreaktor nach Anspruch 13, **dadurch gekennzeichnet, daß** das Fluidrohr (78) aus einem Quarzglasrohr gebildet ist.

15. Mikrowellenreaktor nach einem der vorangehenden Ansprüche, **dadurch gekennzeichnet, daß** zur konvektiven Kühlbarkeit des Fluids im Aktivatorraum (80) dieses in turbulenter Strömung durch diesen geführt ist.

16. Mikrowellenreaktor nach einem der vorangehenden Ansprüche, **dadurch gekennzeichnet, daß** der Hohlleiter (12) so abstimmbar ist, daß eine Wellenlänge der stehenden Mikrowelle einstellbar ist.

17. Mikrowellenreaktor nach einem der vorangehenden Ansprüche, **dadurch gekennzeichnet, daß** der Hohlleiter (12) so abstimmbar ist, daß ein Wellenbauch der stehenden elektromagnetischen Welle im Aktivatorraum (80) liegt.

18. Verfahren zur Steuerung von Reaktionen von aktivierten Molekülen, bei welchem ein Fluid mit den Molekülen durch einen Aktivatorraum geführt wird, welcher mit einer stehenden elektromagnetischen Welle beaufschlagt ist und in dem die Moleküle durch Dissoziation und/oder Ionisation aktiviert werden, **dadurch gekennzeichnet, daß** die aktivierten Moleküle vom Aktivatorraum durch ein Metallgitter hindurch in einen Reaktionsraum geführt werden, in welchem sie als Reaktanden eingesetzt werden.

19. Verfahren nach Anspruch 18, **dadurch gekennzeichnet, daß** in den Aktionsraum weitere Reaktionspartner für die aktivierten Moleküle eingeführt werden.

20. Verfahren nach Anspruch 18 oder 19, **dadurch gekennzeichnet, daß** die Temperatur im Reaktionsraum unabhängig von dem Aktivatorraum gesteuert wird.

21. Verfahren nach einem der Ansprüche 18 bis 20, **dadurch gekennzeichnet, daß** für den Aktivatorraum und den Reaktionsraum unabhängige Kühlsysteme vorgesehen sind.

## Claims

1. Microwave reactor, comprising a microwave generator, a waveguide (12), which is coupled to the microwave generator and in which a standing electromagnetic wave can be generated, a fluid pipe (78), through which a fluid can be conducted transversely to the direction of propagation of the standing electromagnetic wave in a fluid guidance direction (26), whereby there is formed an activator chamber (80), in which molecules can be activated in the fluid flow through dissociation and/or ionisation, and, following the activator chamber (80) in the fluid guidance direction (26), a reaction chamber (92), in which activated molecules can be used as reactants,
**characterised in that** the activator chamber (80) is spatially separated from the reaction chamber (92) by a metal grid (90).

2. Microwave reactor according to Claim 1, **characterised in that** the reaction chamber (92) comprises one or more coupling-in connection(s) by means of which reaction partners can be delivered to the activated molecules.

3. Microwave reactor according to Claim 1 or 2, **characterised in that** the temperature in the reaction chamber (92) can be controlled substantially independently of the temperature in the activator chamber (80).

4. Microwave reactor according to any one of the preceding Claims, **characterised in that** the activator chamber (80) and the reaction chamber (92) have separate cooling systems (84, 94).

5. Microwave reactor according to any one of the preceding Claims, **characterised in that** the activator chamber (80) has a cylindrical shape.

6. Microwave reactor according to Claim 5, **characterised in that** one or more annular channels (82) concentrically surround the activator chamber (80) as cooling channels.

7. Microwave reactor according to any one of the preceding Claims, **characterised in that** silicone oil is provided as the cooling liquid for the activator chamber (80).

8. Microwave reactor according to any one of the preceding Claims, **characterised in that** the reaction chamber (92) has a cylindrical shape.

9. Microwave reactor according to Claim 8, **characterised in that** the reaction chamber (92) is surrounded by one or more annular channels (96) as coolant channels.

10. Microwave reactor according to any one of the preceding Claims, **characterised in that** the temperature of the reaction chamber (92) is controlled by means of coolant acting on reaction chamber walls.

11. Microwave reactor according to any one of the preceding Claims, **characterised in that** the activator chamber (80) is delimited by a first metal grid (88) and a second metal grid (90) which is disposed at a spacing in the fluid guidance direction (26).

12. Microwave reactor according to any one of the preceding Claims, **characterised in that** a mesh aperture of a metal grid (88; 90) is smaller than half a wavelength of the standing electromagnetic wave.

13. Microwave reactor according to any one of the preceding Claims, **characterised in that** the activator chamber (80) and the reaction chamber (92) are formed in the fluid pipe (78).

14. Microwave reactor according to Claim 13, **characterised in that** the fluid pipe (78) is formed from a quartz glass pipe.

15. Microwave reactor according to any one of the preceding Claims, **characterised in that**, in order that it may be cooled by convection, the fluid in the activator chamber (80) is conducted through the latter in a turbulent flow.

16. Microwave reactor according to any one of the preceding Claims, **characterised in that** the waveguide (12) can be adjusted such that a wavelength of the standing microwave can be set.

17. Microwave reactor according to any one of the preceding Claims, **characterised in that** the waveguide (12) can be adjusted such that an antinode of the standing electromagnetic wave lies in the activator chamber (80).

18. Method for controlling reactions of activated molecules, in which a fluid is conducted with the molecules through an activator chamber which is acted upon by a standing electromagnetic wave and in which the molecules are activated by dissociation and/or ionisation, **characterised in that** the activated molecules are conducted from the activator chamber through a metal grid into a reaction chamber in which they are used as reactants.

19. Method according to Claim 18, **characterised in that** further reaction partners for the activated molecules are introduced into the reaction chamber.

20. Method according to Claim 18 or 19, **characterised in that** the temperature in the reaction chamber is controlled independently of the activator chamber.

21. Method according to any one of Claims 18 to 20, **characterised in that** independent cooling systems are used for the activator chamber and the reaction chamber.

## Revendications

1. Réacteurs hyperfréquences comprenant un générateur hyperfréquences, un guide d'onde (12), lequel est couplé au générateur de micro-ondes et dans lequel une onde électromagnétique peut être générée, un tube à fluide (78), par lequel un fluide peut être introduit dans une direction d'introduction de fluide (26) transversalement par rapport à la direction de propagation de l'onde électromagnétique, ce par quoi un espace d'activation (80) est formé, dans lequel des molécules peuvent être activées dans le flux du fluide par dissociation et/ou ionisation, et un espace de réaction (92) qui suit l'espace d'activation (80) dans la direction d'introduction du fluide (26), dans lequel les molécules activées peuvent être utilisées comme réactants, **caractérisé en ce que** l'espace d'activation (80) est séparé spatialement de l'espace de réaction (92) par une grille métallique (90).

2. Réacteurs hyperfréquences selon la revendication 1, **caractérisé en ce que** l'espace de réaction (92) comporte un ou plusieurs raccords de couplage, via lesquels le ou les partenaires de réaction peuvent être amenés aux molécules activées.

3. Réacteurs hyperfréquences selon la revendication 1 ou 2, **caractérisé en ce que** la température dans l'espace de réaction (92) est essentiellement pilotée indépendamment de l'espace d'activation (80).

4. Réacteurs hyperfréquences selon l'une quelconque des revendications précédentes, **caractérisé en ce que** l'espace d'activation (80) et l'espace de réaction (92) comportent des systèmes de refroidissement (84, 94) séparés.

5. Réacteurs hyperfréquences selon l'une quelconque des revendications précédentes, **caractérisé en ce que** l'espace d'activation (80) a une forme cylindrique.

6. Réacteurs hyperfréquences selon la revendication 5, **caractérisé en ce qu'**un ou plusieurs canaux annulaires (82) entourent l'espace d'activation (80) de façon concentrique comme canaux de refroidissement.

7. Réacteurs hyperfréquences selon l'une quelconque des revendications précédentes, **caractérisé en ce que** de l'huile de silicones est prévue comme liquide de refroidissement pour l'espace d'activation (80).

8. Réacteurs hyperfréquences selon l'une quelconque des revendications précédentes, **caractérisé en ce que** l'espace de réaction (92) a une forme cylindrique.

9. Réacteurs hyperfréquences selon la revendication 8, **caractérisé en ce que** l'espace de réaction (92) est entouré par un ou plusieurs canaux annulaires (96) comme canaux de fluide de refroidissement.

10. Réacteurs hyperfréquences selon l'une quelconque des revendications précédentes, **caractérisé en ce qu'**un pilotage de la température de l'espace de réaction (92) est prévu via une alimentation en fluide de refroidissement par les parois de l'espace de réaction.

11. Réacteurs hyperfréquences selon l'une quelconque des revendications précédentes, **caractérisé en ce que** l'espace d'activation (80) est limité par une première grille métallique (88) et une seconde grille métallique (90) disposée à distance dans la direction d'introduction du fluide (26).

12. Réacteurs hyperfréquences selon l'une quelconque des revendications précédentes, **caractérisé en ce qu'**une ouverture de maille d'une grille métallique (88 ; 90) est inférieure à une demi longueur d'onde de l'onde électromagnétique.

13. Réacteurs hyperfréquences selon l'une quelconque des revendications précédentes, **caractérisé en ce que** l'espace d'activation (80) et l'espace de réaction (92) sont formés dans le tube à fluide (78).

14. Réacteurs hyperfréquences selon la revendication 13, **caractérisé en ce que** le tube à fluide (78) est formé à partir d'un tube de verre de quartz.

15. Réacteurs hyperfréquences selon l'une quelconque des revendications précédentes, **caractérisé en ce que**, pour la capacité de refroidissement convective du fluide dans l'espace d'activation (80), le fluide est amené dans un courant turbulent par celui-ci.

16. Réacteurs hyperfréquences selon l'une quelconque des revendications précédentes, **caractérisé en ce que** le guide d'onde (12) peut être réglé, de sorte qu'une onde hyperfréquences stationnaire peut être définie.

17. Réacteurs hyperfréquences selon l'une quelconque des revendications précédentes, **caractérisé en ce que** le guide d'onde (12) est réglé, de sorte qu'une onde électromagnétique stationnaire se trouve dans l'espace d'activation (80).

18. Procédé de pilotage de réactions de molécules actives, pour lequel un fluide est introduit avec des molécules par un espace d'activation, lequel est alimenté par une onde électromagnétique et dans lequel les molécules sont activées par dissociation et/ou ionisation, **caractérisé en** en ce que les molécules actives sont introduites par l'espace d'activation par une grille métallique dans un espace de réaction, dans lequel elles sont utilisées comme réactants.

19. Procédé selon la revendication 18, **caractérisé en ce que** dans l'espace d'action, d'autres partenaires de réaction sont introduits pour les molécules actives.

20. Procédé selon la revendication 18 ou 19, **caractérisé en ce que** la température dans l'espace de réaction est pilotée indépendamment de l'espace d'activation.

21. Procédé selon l'une quelconque des revendications 18 à 20, **caractérisé en ce que** des systèmes de refroidissement sont prévus pour l'espace d'activation et l'espace de réaction.
